# EUROPEAN PATENT SPECIFICATION

(11) **EP 2 333 793 B1**
(45) Date of publication and mention of the grant of the patent: **08.02.2012**
(21) Application number: 09178528.7
(22) Date of filing: 09.12.2009
(51) Int. Cl.: H01B 12/10, H01L 39/14, H01L 39/24

(54) **Superconductors with improved mechanical strength**
Supraleiter mit verbesserter mechanischer Festigkeit
Supraconducteurs dotés d'une résistance mécanique améliorée

(43) Date of publication of application: 15.06.2011
(73) Proprietor: Bruker BioSpin AG, 8117 Fällanden (CH)
(72) Inventor: Buta, Florin, 1227 Les Acacias (CH); Flükiger, René, 1228 Plan-les-Ouates (CH)
(74) Representative: Schmitt, Martin

(56) References cited:
- EP-A1- 2 099 080
- JP-A- 9 050 721
- JP-A- 9 082 152
- JP-A- 11 353 961
- US-A- 3 754 095
- US-A- 4 863 804

## Description

### 1. Field of the invention

The invention relates to a component comprising a hollow tube and superconducting material or superconductor precursor material such as superconductor precursor rods arranged within the bore of the tube. The tube comprises a matrix of a first ductile material and a plurality of continuous filaments are distributed in the matrix; the filaments are made of a second ductile material and extend along the axial direction of the tube over a length that is at least ten times larger than the outer diameter of the tube.

More generally, the invention relates to the fabrication of superconductors used to wind magnet coils capable of generating high magnetic fields, particularly to the fabrication of superconductors with improved mechanical strength, capable of sustaining large electromagnetic forces without damage. High field magnets built with such superconductors are used for example in nuclear magnetic resonance, particle accelerators and colliders, nuclear fusion devices, research of magnetic and electronic properties of materials.

### 2. Background of the invention

All superconductors currently used to wind magnets able to generate magnetic fields in excess of around 12 T are based on superconducting materials, either intermetallic or ceramic, that are brittle and hard. These materials will deform very little before they completely fail by breakage when exposed to tensile mechanical forces.

The hardness and brittleness of these materials are in fact the reason some of the high field superconductors (like those based on Nb₃Sn an Nb₃Al) are manufactured from ductile constituents that are co-deformed from a large diameter assembly to an elongated conductor with multiple filaments in the shape of a wire or a tape which is subsequently wound into a coil and then heated to suitably chosen temperatures to react some of the constituents into superconducting filaments.

In other cases, like the superconductors based on Bi₂Sr₂CaCu₂O₈₋ₓ (BSCCO-2212), Bi₂Sr₂Ca₂Cu₃O_{10-y} (BSCCO-2223) and MgB₂, the precursors are fine powders of brittle nature distributed to form filaments in a ductile matrix. The co-deformation to form long wires or tapes is possible in this case by the rearrangement of the powder particles to accommodate the reduction in filament size during the deformation process. A heat treatment is also applied after the magnet coil is wound (in rare instances before the winding) to react the powders or improve their connectivity.

Even before a single filament in a superconductor completely breaks under the action of the applied tensile stress, the current carrying capacity of the superconductor is affected by the applied stress. Initially, as the stress is increased, there is an increase in the current carrying capacity (namely critical current) towards a maximum. In this range, if the applied stress is returned to zero, the critical current is restored to the initial value from before the application of stress. This is the so called reversible regime, in which the change in critical current density is caused by modifications in the elastic strain state of the superconductor. The initial increase in the critical current is usually associated with the existence of a slight compression of the superconducting filaments coming from the metal matrix that contains them, due to the different thermal contraction coefficients which have an effect upon cooling of the superconductor wire, e.g. from a reaction temperature to room temperature, and/or from room temperature to a cryogenic operation temperature such as 4.2 K.

In some superconductors (like those based on Nb₃Sn and Nb₃Al) the reversible behavior continues over a certain range of stresses (and corresponding strains) on the decrease in critical current that follows the maximum, before an irreversible degradation of the critical current takes place, i.e. the critical current does not return to initial value when the stress is removed. In other superconductors (like those based on BSCCO-2212, BSCCO-2223, MgB₂) there is a very sharp decrease in the critical current once the applied stress exceeds a certain value and the initial value cannot be restored. The irreversible damage sets in suddenly, without any sign showing its imminence, being caused by cracks that develop in the superconducting material, wherein the cracks can extend partially or completely through an affected filament.

During the operation of a superconducting magnet generating a high magnetic field, the current carrying superconductor is exposed to a Lorentz force caused by the interaction between the electrical current passing through the superconductor and the magnetic field it generates. The direction of the Lorentz force is perpendicular to the direction of the local magnetic field and also to the direction of the current in the superconductor so that in the case of a solenoidal coil, it acts in radial direction, towards the exterior of the coil. At the superconductor level this also translates into a tensile force that tries to stretch the filaments.

As the magnitude of the Lorentz force acting on the unit length of superconductor is proportional to the current passing through it and the local magnetic field, and the corresponding tensile stress is proportional to the local bending radius, it is found that for usual high field magnets of solenoidal design the tensile stress in the superconductor depends on the position in the winding, with the highest stresses in winding sections located in the middle of the coil, where the radius is somewhat larger and the local magnetic fields have higher values than at the ends of the coil. Similar regions with high tensile stresses can be found in other high field magnet designs. The tensile stress values in these regions can be extremely high. If the superconductor is not suitably chosen, the limit for irreversible damage can be exceeded, leading to an irremediable degradation of the performance of the magnet.

There are also cases in which the tensile stress acting on the superconductor can momentarily be significantly higher than those present due to the Lorentz forces. For example, thermally induced local transitions to the normal state caused by small disturbances can propagate and extend to the whole magnet leading to the release of large amounts of heat that induce thermo-mechanical stresses in the winding. It is imperative then to leave a respectable safety margin to prevent the destruction of the superconducting magnet when such events occur.

In the design of a superconducting magnet, all these factors are taken into account, with the superconductors being selected based on their electrical and mechanical properties. In some cases the superconductors available in their standard configurations meet the requirements, but to satisfy the demands of magnets with increasingly higher fields, the manufacturers have introduced the so called reinforced superconductors. Their improved mechanical properties are obtained by using matrix materials with better mechanical properties or by the addition of reinforcing elements made of strong materials in the structure of the superconductor. Higher stresses can be supported by such reinforced superconductors without reaching the irreversible degradation limit.

For bronze route Nb₃Sn superconductors, the use of a bronze matrix with Be additions [1] was proposed as a method of improving the strain characteristics of the wire. More recently, dispersion strengthened Cu was used as a matrix for internal Sn route Nb₃Sn superconductors [2-4]. For oxide powder in tube type superconductors (like BSCCO-2223 and BSCCO-2212), the matrix (usually Ag or Ag alloy) containing the filaments can be strengthened with discrete particles of other metals [5] or metal oxides [6-9].

Alloying the matrix containing the filaments presents some drawbacks. First, the electrical and thermal conductivity of the matrix are reduced, which affects their electrical and thermal stability, i.e. their ability to quickly eliminate the effect of small disturbances. Additionally, the gain in strength is not always as high as needed. It has also been proposed to use continuous reinforcing elements in the structure of the superconductor. The material and size of these reinforcing elements can be adjusted to obtain the desired properties while the matrix can be left unaffected.

In the initial attempts to strengthen Nb₃Sn superconductors with continuous reinforcing elements, these were added to the wire at the end of the fabrication process. This was done for example in the form of W filaments in a Cu matrix soldered to the wire with the aid of a Cu channel containing the already reacted wire [10], an approach that has certain limitations given the brittleness of the reacted Nb₃Sn. A more feasible approach for the reinforcement of long lengths of superconductor is the compaction of multiple Nb₃Sn wires around a steel wire in a Cu tube [11, 12], but this still has certain disadvantages. Working with the Nb₃Sn wires at their final size is one of them, the wire length at this stage being significant which makes their assembly a more delicate task, not to mention the fact that insertion in Cu tubes has length limitations. A proposed alternative of wrapping in Cu sheet, instead of insertion in Cu tubes, requires additional expensive machinery. There is also a limited flexibility in adjusting the Cu content of wires reinforced in such a way; these wires will always have Cu contents higher than needed for stability reasons and therefore a needlessly low overall current density (the current being all carried by the superconductor).

The same disadvantages of length limitation and high final Cu content applies to the method of assembling multiple steel wires around a finished Nb₃Sn superconductor wire [13]. One implementation consisted of electroplating with Cu the assembly of reinforcing filaments loosely cabled with one or more superconducting wires followed by slight deformation by swaging [14]. In this case the severe length limitation is further aggravated by the known low speeds of electrodeposition. In a related approach, for a more uniform distribution of the filaments around the central superconductor wire, the reinforcing filaments were placed alternately with Cu wires in the space between the superconductor wire and an external Cu tube [15, 16]. A slight deformation by wire drawing was used to compact the resulted assembly. Not only the very high Cu to superconductor ratio that reduces the overall current carrying capacity, but also suspected partial slipping between the constituents [15] can be added to the list of drawbacks of this method. The partial slipping is not totally unexpected given the fact that the line of separation (most probably a row of fine voids) between the superconductor wire and the assembly containing reinforcing filaments is clearly visible in [15], what is an indication that an intimate bonding did not form during the preparation of the reinforced wire.

The length limitation is eliminated for the technique proposed by K. Noto et al. [17] of enclosing a finished rectangular wire between two specially shaped Cu profiles strengthened with Al₂O₃ dispersions. The profiles will lock onto each other during the subsequent mechanical deformation and so lead to a monolithic rectangular conductor. In addition to the high costs of preparing such specially shaped profiles, the lower limit for the amount of reinforcing material that must be added by this technique is relatively high. This reduces the overall current density of the superconductor reinforced by this technique.

The method of S. Pourrahimi [18] consists in cladding the almost finished superconductor wire by folding a continuous sheet of a high strength material around the wire (with or without the subsequent welding of the seam), followed by additional wire drawing to eliminate the voids between the central wire and the cladding. The enclosing of the superconductor wire in a low thermal conductivity cladding material (iron, nickel, molybdenum, niobium, vanadium, tantalum and their alloys) is seen as a gain in electromagnetic stability for certain applications because the external thermal disturbances will not easily propagate to the superconductor. However, the high electrical resistivity of the cladding may be a disadvantage in other applications, for examples in Rutherford cables. Special machinery and custom sized metal sheets are needed for the implementation of this method. There is also a lower limit for the volume percentage of reinforcing material, below which the cladding/wire assembly cannot be compacted by wire drawing.

For the oxide powder in tube type superconducting tapes (BSCCO-2223), a preferred reinforcing technique for the already fabricated tapes is to join the superconductor tape to one or two laminates in a specially designed apparatus [19].

Further methods of adding reinforcing elements to the superconductors at some stage in the fabrication process rather than at doing this on the finished wire are known. The assembling of the constituents can be done when they have a limited length, and these constituents will typically be better bonded in the final wire.

One of the earliest wires fabricated with integrated reinforcement had oxide dispersion strengthened (ODS) Cu replacing partially or completely the pure Cu stabilizer of the last extrusion in the fabrication of bronze route Nb₃Sn wires [2]. A continuous outer layer of oxide dispersion strengthened Cu completely separates the stabilizer Cu and/or superconducting filaments from the outside, which has the disadvantage that it limits the current sharing and heat transfer to/from the outside. Partial replacement of the stabilizer pure Cu with oxide dispersion strengthened Cu was used later for tube type internal Sn Nb₃Sn wires [3, 20]. The oxide dispersion strengthened Cu has the advantage of relatively low electrical resistivity, but the gain in mechanical strength for the reinforced wires does not satisfy the demands of many applications.

Following the proposition of using Cu-Nb composite material, with yield stresses two times higher than oxide dispersion strengthened Cu [21], bronze route Nb₃Sn wires in which some of the Cu stabilizer was replaced with such composite [22] were fabricated. The Cu-Nb composites provide a good combination of high strength and relatively low electrical resistivity but they are quite expensive to produce.

Initially proposed as a reinforcing stabilizer [23], cold worked Ta was eventually adopted for reinforcing the Nb₃Sn superconducting filaments by placing a Ta core at the center of each filament [24] as proposed in earlier studies [25-27].

A core of a reinforcing material in the center of the finished wire as proposed earlier by C. Spencer [12] has become the approach of choice for bronze route Nb₃Sn wires (see for example [28] and [29]), the Ta reinforcing material being added to the wire during the fabrication process, in the billet of the final extrusion.

For powder in tube type Nb₃Sn superconductors a sleeve of Ta or other suitable reinforcing material surrounding the Nb (or Nb alloy) tube was proposed as to fulfil the role of reinforcement as well as of Sn diffusion barrier [30].

The fabrication of superconductors with reinforcing elements has proven itself straightforward and without major technical difficulties for the cases in which the addition of the reinforcing elements is followed by an extrusion step during which all the constituents of the wire become bonded together because of the combined effect of high pressure and high temperature. This is the case of the Nb₃Sn superconductors fabricated by the bronze route. For other types of superconducting wires, extrusions cannot be performed beyond a certain stage in the fabrication process. For example in the manufacturing process of the internal Sn type Nb₃Sn wires, after the insertion of the Sn cores in the subelements, extrusion processes cannot be employed anymore because they would fail because of the presence of molten Sn at the extrusion temperature. The reduction in area during the extrusion of billets for the fabrication superconductors by the powder in tube technique (like BSCCO-2212 and MgB₂) is severely limited by the simultaneous presence of relatively soft materials (the matrix) and cores constituted of hard powders, to levels where it becomes impractical to use extrusion steps.

In most cases in which for some reason it is not possible to extrude after a certain stage in the processing, a number of precursor rods (sometimes named subelements) are assembled in a tube and then deformed together by a combination of swaging, rolling and wire drawing to form the final wire, the process being often called cold restacking. The mechanical properties of the elements being assembled and of the tube material are very important; too large differences between them lead to deformation problems and a lack of proper bonding between the constituents. It is for this reason that reinforcing elements (having large Young's modulus and yield strength) are very difficult to add at the cold restack stage of the fabrication.

Patent document JP9082152 discloses a superconducting cable with a tube having a copper matrix with filamentary particles of niobium dispersed in the matrix. However, these particles have a length on the micrometer scale and random alignment.

### 3. Object of the invention

It is the object of the invention to provide a good quality mechanical reinforcement of superconductor wires, in particular which can be used without later hot extrusion.

### 4. Short description of the invention

This object is achieved, in accordance with the invention, by a component comprising a hollow tube as introduced in the beginning and specified in claim 1.

This invention provides a solution to the problem of fabricating reinforced superconductor wires by processes that involve the assembly of precursor constituents in a tube followed by mechanical deformation to elongate the assembly into a wire or tape. The solution applies particularly to cases where mechanical deformation of these assemblies (with total elongation higher than ∼25) is done at ambient temperature or at moderately high temperature, of typically no more than 300°C. The reinforcement of superconductor wires of these types has certain limitations for the prior art techniques, namely in the choice of materials and the flexibility in selecting the content of reinforcing material.

The superconductor wires fabricated according to this invention are assembled in special hollow tubes provided with reinforcing material distributed in the wall of the tube. The hollow tubes (or hollow members), typically of cylindrical exterior shape with a centrally placed bore, are fabricated in advance with the wall consisting of a ductile matrix containing a distribution of continuous filaments (or bundles of continuous filaments) made of a ductile material along the length of the tube. Wires fabricated with the aid of the inventive hollow tube have an increased mechanical strength because of the presence of reinforcement material that can be well bonded to the rest of assembly, especially to the softer materials present therein.

The continuous filaments each have a length that is at least ten times larger than the outer diameter of the tube, and preferably have a length that corresponds to the tube length. The filaments typically have an outer diameter much smaller than the tube wall thickness. However, the filament diameter may also be up to the tube wall thickness. The filaments typically have a round, oval or hexagonal cross-section, but may also have other shapes, such as a polygonal or an annular sector-like shape. Typically, every filament or at least a majority of filaments is completely surrounded by matrix material, seen in the cross-section. In general, the filaments are distributed basically equally over the circumference of the tube and over the tube wall thickness. Typically, there are at least 6 filaments within the matrix, but often there are more than 40 or even more than 100 filaments distributed within the matrix. The hollow tube may have an arbitrary outer and inner shape, however, round or polygonal shapes are preferred. The bore of the hollow tube is originally empty, but is intended for being filled with superconductor precursor material such as a bundle of superconductor precursor rods.

Usually the matrix material (metal or alloy) has electrical and thermal conductivity higher than the filaments, whereas the filament material has higher yield strength than the matrix material. However, the reverse configuration in which the filaments are made of the higher electrical and thermal conductivity material whereas the matrix is made of a higher yield strength material may also be used. This could be preferred if the electrical and thermal conductivity requirements are not stringent and mechanical property or deformation considerations recommend having a high content of high strength material. It could also be of an advantage in some instances to not have the high electrical and thermal conductivity material in contact with the precursors being assembled inside the tube to prevent undesirable chemical reactions during the reaction heat treatments that may need to be applied to form the superconducting phase.

The filaments embedded in the wall of the tube may be sheathed with a third ductile material, different from the material of the matrix and of the filaments. When suitably chosen, such a sheath will act as a diffusion barrier between the filament and the matrix, preventing or minimizing the interdiffusion or reaction of the filaments material with the matrix material. Similar layers of a third material may be used to separate the wall of the tube in different annular regions. For example, a diffusion barrier consisting of layer of a third material may be present at the inner surface (bore wall) of the tube to separate the superconductor precursor subelements from the material of the matrix to prevent interdiffusion or reaction.

During the fabrication process of the tubes of this invention, usually by hot extrusion followed by tube drawing, a good bonding is achieved between the matrix material and the filaments in such a way that during subsequent deformation the formed composite behaves like a single material of high strength. Not only that this increases the mechanical strength of the final superconductor wire, but the deformation of the assembly of precursor rods in the tube of this invention is less prone to failure by wire breakages.

In accordance with the invention, also a method is provided for the fabrication of reinforced superconductors by the assembly of superconductor precursors in the hollow tube of this invention followed by mechanical deformation to form a rod, wire or tape. The superconductor precursors can be ductile precursor rods made of several components, one or more of these components being superconductors in the supplied form or becoming superconductors as a result of a reaction heat treatment. The precursor rods are typically of the same size and are hexagonal or round in shape. The precursors inserted in the bore of the tube can also be powders or mixtures of powders that are superconductors or will become superconductors upon a reaction heat treatment.

The shape of the interior surface of the tube is selected such as that upon insertion of precursor rods into the bore (hole) of the tube, a minimum of clearance remains between the bundle (assembly) of rods and the inner face of the tube. This minimizes the distortion of the precursor rods during the subsequent mechanical deformation.

During the mechanical deformation (by wire drawing, swaging or the like) applied to elongate the assembly of precursors in the tube, good bonding is achieved between the precursors themselves and between the precursors and the tube. This is possible when using the tubes of this invention because there is more flexibility in choosing the materials coming in direct contact. The mechanical deformation of the assembly by wire drawing or other methods, with total elongations typically higher than ∼25, creates the conditions for good bonding between the constituents, with no or insignificant amounts of voids at the former interfaces. The former interfaces between similar materials will become practically invisible with optical microscopy. In the case where precursor rods are inserted in the tube of this invention to be deformed into a wire, at the end of the deformation process the typical diameters of the resulted wire are 0.5-2 mm, and typical effective diameters of superconductor precursor rods are 20-50 µm. With all constituents well bonded, the conditions are met for the good sharing of electrical currents, heat and mechanical stresses that is necessary for a stable, high strength superconductor wire.

Heat treatments may need to be applied on the resulted wire or tape to render its filaments superconducting at the operation temperature, but they will not lead to a dramatic change in the properties of the assembly of reinforcing filaments in the matrix of the tube if the materials are properly chosen.

The reinforced superconductor wires fabricated by the method of this invention also present improved thermal and electrical conductance in radial direction when compared with reinforced wires fabricated by prior art methods in which the reinforcing material forms a continuous ring that surrounds the superconducting filaments. These reinforcing materials of low electrical and thermal conductivity, and such ring-type reinforcement configurations are less favorable to the current sharing between different wires in cables made of multiple wires and/or to transferring to the outside any heat generated in the superconducting filaments. In contrast, the high electrical and thermal conductivity paths that may be provided by the matrix between the filaments of the tubes of this invention will help removing the electrical and/or thermal disturbances in the wire.

In general, by choosing the fractions and distribution of matrix and filament in the hollow tube, a wide range of reinforcement and conductivity values are available. Further flexibility in selecting the overall content of reinforcing material or in having high conductivity filaments in a strong matrix can be achieved by including an additional step of matrix material removal from the periphery of the wire by shaving or chemical etching processes, wherein the step is typically employed towards the end of the mechanical deformation sequence. The volume percentage of the filaments can be increased like this. For the type of tubes having the filaments made of the higher electrical and thermal conductivity filaments, these filaments could be exposed in such a way at the surface of the wire to enhance the transfer of heat and/or electrical current, even though they were completely embedded in the wall during the fabrication of the tube.

Reinforced superconductor wires or tapes with a large variety of precursor rods can be fabricated by the method of this invention, including: internal Sn type precursor subelements of stacked rod configuration for Nb₃Sn superconductors, internal Sn type precursor subelements of tube configuration for Nb₃Sn superconductors, powder in tube type precursor subelements for Nb₃Sn, BSCCO or MgB₂ superconductors. If the precursor rods (subelements) do not have an integrated diffusion barrier to prevent the diffusion of certain elements from these rods to the high electrical conductivity matrix of the tube with reinforcing filaments, it is possible to include a diffusion barrier made of a suitably selected material in the construction of the tube of this invention. For example, in the case of Nb₃Sn superconductors assembled with subelements having no integrated barrier, a continuous layer of Nb or Ta surrounding the internal surface of the tube of this invention would prevent the diffusion of Sn into the Cu matrix during the reaction heat treatment and so maintain a high electrical conductivity for the Cu contained in the wall of the tube.

The present invention equally applies to the two variants of the internal Sn process for the fabrication of the Nb₃Sn superconductors: the rod type and the tube type.

For certain types of superconductors, the tubes of this invention can be used not only for the receiving of an assembly of precursors, but also for the fabrication of the precursors themselves. For example, powder in tube type superconductors like MgB₂ need tubes with good overall mechanical properties for the successful deformation of the powder packed precursor. The electrical and thermal stability of the final wires would greatly benefit from presence of paths of high electrical and thermal conductivity in structure of the precursor, specifically in the wall of the tube.

### 5. Preferred variants of the invention

An advantageous variant of the inventive tube provides that the first ductile material of the matrix is a material, in particular metal or alloy, of high electrical and thermal conductivity, i.e. with an electrical conductivity σ1 and a thermal conductivity k1 which are larger than the electrical conductivity σ2 and the thermal conductivity k2 of the second ductile material of the filaments,
and that the second ductile material of the filaments is a material, in particular a metal or alloy, of high yield strength, i.e. with a yield strength ys2 which is larger than the yield strength ys1 of the first material of the matrix. In this case, the matrix can focus on its protection function in the quench case, but is mechanically strengthened by the filaments. Note that typically, σ1 is equal to or larger than 5*10⁷ S/m and k1 is equal to or larger than 350 W/(mK). The values are measured at room temperature each.

An alternative, also advantageous variant is characterized in
that the second ductile material of the filaments is a material, in particular metal or alloy, of high electrical and thermal conductivity, i.e. with an electrical conductivity σ2 and a thermal conductivity k2 which are larger than the electrical conductivity σ1 and the thermal conductivity k1 of the first ductile material of the matrix,
and that the first material of the matrix is a material, in particular metal or alloy, of high yield strength, i.e. with a yield strength ys1 which is larger than the yield strength ys2 of the second material of the filaments. In this case, the matrix can effectively strengthen mechanically the superconducting wire that is produced from the hollow tube. Typically, σ2 is equal to or larger than 5*10⁷ S/m and k2 is equal to or larger than 350 W/(mK). The values are measured at room temperature each.

In a preferred embodiment, the material of high electrical and thermal conductivity is from the group Cu, Cu alloy, Ag, Ag alloy. These materials show good results in practice. However, for certain types of superconductors the material of high electrical and thermal conductivity can also be from the group Al, Al alloy, Ni, Ni alloy, Fe, Fe alloy.

Also preferred is an embodiment, wherein the material of high yield strength is from the group Nb, Nb alloy, Ta, Ta alloy, Ti, Ti alloy, V, V alloy, Zr, Zr alloy, Hf, Hf alloy, Mo, Mo alloy, Fe, Fe alloy, Ni, Ni alloy, Cu alloy. These materials also show good results in practice.

Further preferred is an embodiment wherein the material of high yield strength is a metal-matrix composite made of
- a metal matrix, in particular of Cu or a Cu-based solid solution alloy, and
- particles or non-continuous fibers, in particular of one or more of the materials Nb, Nb alloy, Ta, Ta alloy, Ti, Ti alloy, V, V alloy, Zr, Zr alloy, Hf, Hf alloy, Mo, Mo alloy, Fe, Fe alloy, Ni, Ni alloy. The non-continuous fibers strengthen the matrix material mechanically. The non-continuous fibers have a length much shorter than the tube length, with a typical non-continuous fiber length of 20-1000 µm.

In another preferred embodiment, the tube has a circular outer shape. The circular cross-sectional outer shape is simple to manufacture and well suited for further processing steps, such as wire drawing.

Preferred is also an embodiment, wherein the tube has a bore with a shape that corresponds to the outer shape of a bundle of rods each having a polygonal, in particular hexagonal, or round cross-section. This results in a good fit and hold, and an efficient use of the available space within the hollow tube. Upon insertion of the bundle of rods into the bore (hole), a minimum of clearance remains between the bundle (assembly) of rods and the inner face of the tube. Thus upon wire drawing, good bonding can be achieved. The rods are typically congeneric in size. The bore is typically centrally placed.

Alternatively, the tube has a bore with a circular shape. A bore with a circular (round) cross-section is simple to manufacture. Note that form elements may be inserted into this type of tube, to fill space between the inner wall of the tube and a bundle of inserted rods, wherein the form elements have a shape corresponding to at least a part of a side face of the bundle.

In another preferred embodiment, the ratio AB/AT of the cross-sectional area AB of the bore of the tube and the cross sectional total area AT of the matrix and the filaments is between 0.25 and 9, preferably between 0.5 and 2. In these parameter ranges, both a good mechanical strengthening and good current carrying capacity of a wire can be achieved.

Further, in a preferred embodiment, the filaments distributed in the matrix occupy between 10% and 90%, preferably between 35% and 55%, of the total area AT of matrix and filaments. In this ratio range, good conductivity and good reinforcement can be achieved.

Also within the scope of the present invention is a method for producing a component, in particular wire or rod or tape,
comprising superconducting material or superconductor precursor material arranged in a tube,
characterized by a sequence of the following steps:
a) an inventive hollow tube as described above is provided,
b) superconducting material or superconductor precursor material, in particular a plurality of superconductor precursor rods, is inserted into the bore of the hollow tube,
c) the tube including the superconducting material or superconductor precursor material undergoes a mechanical deformation, wherein the tube is reduced in diameter size. This method provides a reinforced superconductor component by simple means and at low costs. The reinforcement implementation takes place at a cold restack stage. The hollow tubes including the reinforcements are produced in advance to the restacking. Note that after step c), typical tube diameters are 0.5-2mm, and typical effective diameters of superconductor precursor rods are 20-50 µm, in accordance with the invention.

In a preferred variant of the inventive method, step c) is accompanied by or followed by generation of heat, wherein the superconductor precursor material reacts into its corresponding superconductor. This makes the component ready for carrying an electric current at negligible resistance. Heat may be generated by active heating, e.g. in an oven, and/or result from the mechanical deformation. Note that the mechanical deformation may include the application of tensile stress and/or a swaging or the like.

An advantageous variant provides that a part of the tube material is removed from the periphery of the tube, thus reducing the outer diameter of the tube, in particular wherein after the removal of the tube material, filaments are exposed at the outer surface of the tube. By this means, the mechanical and conductivity properties of the tube part of the component can be adjusted. Material removal can e.g. be done by shaving or turning or chemical etching. The tube material removal can be limited to matrix material, in particular when applying etching. The material removal is typically done in the course of step a) or before step c) or after step c).

Also within the scope of the present invention is a component, in particular wire or rod or tape, comprising superconducting material or superconductor precursor material, in particular superconductor precursor rods, arranged in a tube, produced by an inventive method as described above.

In a preferred embodiment of the component, the superconducting material comprises MgB₂ or Nb₃Sn, or the superconductor precursor material is a precursor material for MgB₂ or Nb₃Sn. Note that the precursor material may comprise several compounds.

Further advantages can be extracted from the description and the enclosed drawing. The features mentioned above and below can be used in accordance with the invention either individually or collectively in any combination. The embodiments mentioned are not to be understood as exhaustive enumeration but rather have exemplary character for the description of the invention.

The reinforcement method of this invention can also be used in conjunction with other known methods of reinforcement of superconductor wires and tapes.

### 6. Detailed description of the invention and drawing

The invention is shown in the drawing.
- Fig. 1: shows schematically a cross-section of a first embodiment of an inventive tube, with six half-round continuous filaments made of Ta;
- Fig. 2: shows schematically a cross-section of the tube of Fig. 1, with 109 hexagonally shaped subelements inserted in its bore;
- Fig. 3: shows schematically a cross-section of a second embodiment of an inventive tube, with 144 round continuous filaments made of Ta;
- Fig. 4: shows schematically a cross-section of the tube of Fig. 3, with 109 hexagonally shaped subelements inserted in its bore;
- Fig. 5: shows schematically a cross-section of a third embodiment of an inventive tube, with six continuous filaments of ODS type;
- Fig. 6: shows schematically a cross-section of the tube of Fig. 5, with 253 hexagonally shaped subelements inserted in its bore;
- Fig. 7: shows schematically a cross-section of a forth embodiment of an inventive tube, with a round central bore, and with 16 round continuous filaments made of Cu in its tube wall;
- Fig. 8: shows schematically the tube of Fig. 4, with the continuous filaments exposed at the outer surface of the tube;
- Fig. 9: shows schematically a cross-section of a fifth embodiment of an inventive tube, with sheathed continuous filaments;
- Fig. 10: illustrates the fabrication of a component from an inventive tube, in accordance with the invention.

### Preferred embodiment nr. 1

The tube with reinforcing filament of this preferred embodiment has a Cu matrix and continuous longitudinal filaments made of Ta. The advantage of this combination of materials is that Cu has a high electrical conductivity and that there is negligible diffusion of Ta atoms in the Cu matrix even at the high temperature at which they are exposed during the extrusion necessary to fabricate the tube or during the reaction heat treatments necessary to form the superconducting filaments in the final wire. This embodiment is particularly suitable for the fabrication of reinforced Nb₃Sn superconductor wires by the internal Sn route or by the powder in tube route.

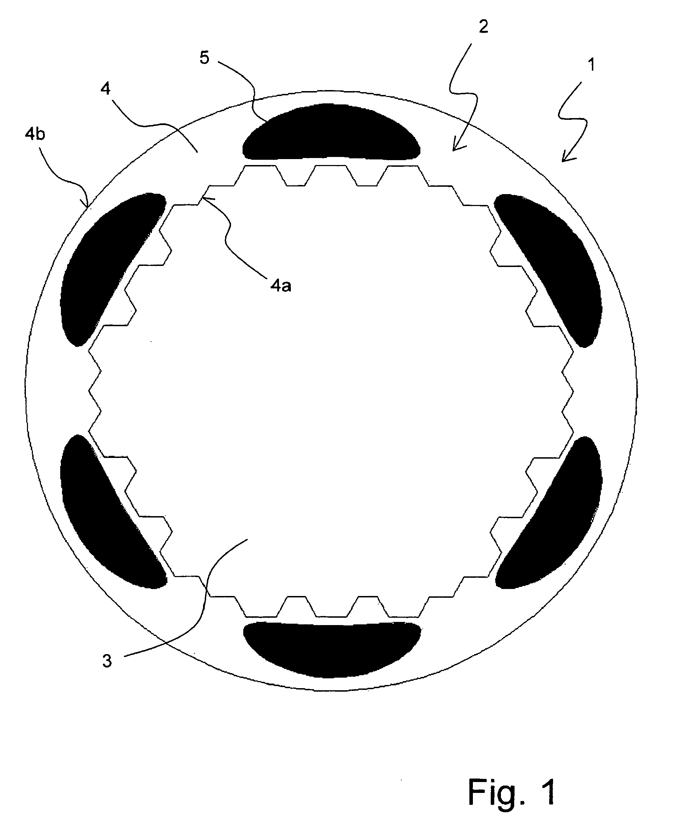

**Fig. 1** presents the cross-section of an inventive tube 1 of the preferred embodiment nr. 1, with the cross-section taken in a plane perpendicular to the axial direction in which the tube 1 extends. The tube 1 has a tube wall 2 which surrounds a central bore (hole) 3. The tube wall 2 comprises a matrix 4 of Cu in which six Ta filaments 5 are embedded. The external shape 4b of the tube 1 is round whereas the internal bore (hole) 3 is shaped for receiving a number of 109 hexagonal subelements.

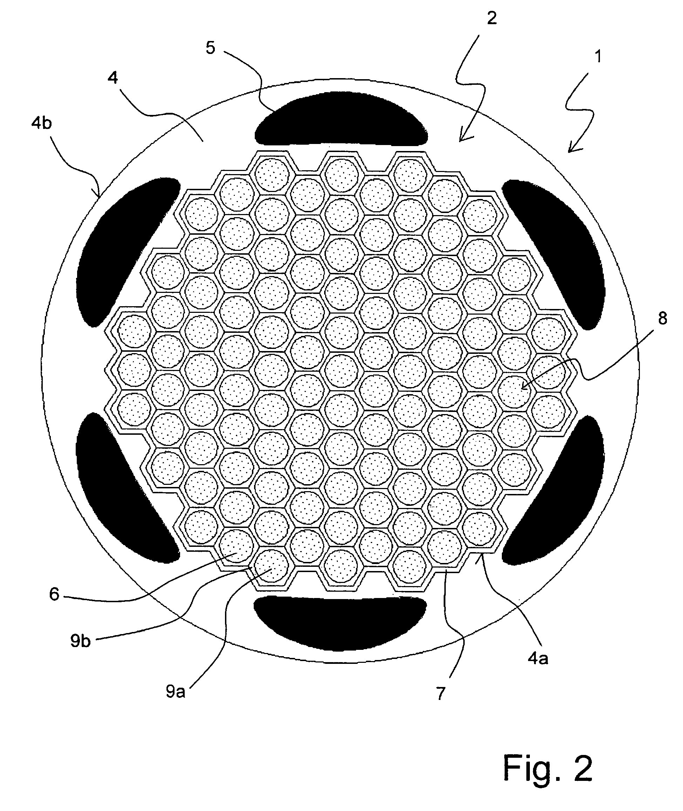

In more detail, compare also **Fig. 2**, the tube 1 has a round exterior shape 4b and the central hole 3 is of a special polygonal shape, able to receive a number of (here) 109 subelements 6 with just a small clearance 7 between the interior wall 4a of the tube 1 and the subelement bundle 8, enough to allow the insertion of all the subelements 6 during assembly. The six reinforcing filaments 5 in the wall 2 of the tube 1 have an ovalized shape given by the tube fabrication process (tube extrusion followed by tube drawing) when starting with round Ta rods in a Cu billet.

In this preferred embodiment, the reinforcing filaments 5 occupy ∼39% of the cross-sectional area of the wall 2 of the tube 1, whereas the central hole 3 takes ∼57% of the total cross-sectional area of the tube 1 (including the bore 3).

A superconductor wire will be prepared by fabricating 109 subelements 6 containing the precursor materials 9a for the formation of a superconducting phase surrounded by a layer of Cu 9b and then assembling these subelements 6 in the described tube 1 (Fig. 2) and mechanically deforming them by wire drawing to form a round wire of a diameter suitable for the winding of magnet coils (usually between 0.5 and 2 mm). In the final wire, the reinforcing filaments 5 will occupy ∼17% of the total cross-sectional area of the wire, the rest of the area being divided between the Cu stabilizer and the 109 superconducting subelements 6 (∼45% of total area when excluding the Cu separating them). The content of reinforcing material and stabilizer Cu of the final wire can be adjusted by changing the size of the six filaments 5 in the wall 2 of tube 1.

For wires prepared using the tube 1 of this embodiment, the size of the superconducting subelements 6 in the final wire with a diameter of 0.80 mm (the so-called effective diameter) will be around 50 µm. A smaller effective diameter can be obtained if a larger number of subelements is assembled in a tube with the central hole reshaped to accept them.

Fig. 2 presents the cross-section of the tube 1 of the preferred embodiment nr. 1, with 109 hexagonal subelements 6 assembled in the specially shaped central hole 3 of the tube 1.

### Preferred embodiment nr. 2

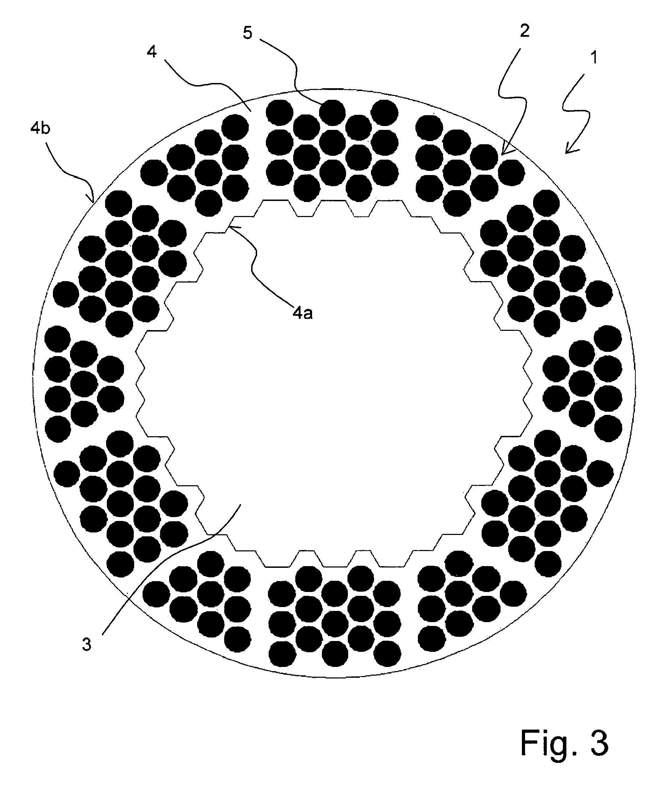

The tube with reinforcing filaments of this preferred embodiment has a Cu matrix 4 and continuous longitudinal filaments 5 made of Ta, compare **Fig. 3**. This embodiment is also particularly suitable for the fabrication of reinforced Nb₃Sn superconductors.

Fig. 3 presents the cross-section of the tube 1 of the preferred embodiment nr. 2, with 144 Ta filaments 5 in the Cu wall 2 of the tube 1. The external shape 4b of the tube 1 is round, whereas the internal bore (hole) 3 is shaped for receiving a number of (here) 109 hexagonal subelements.

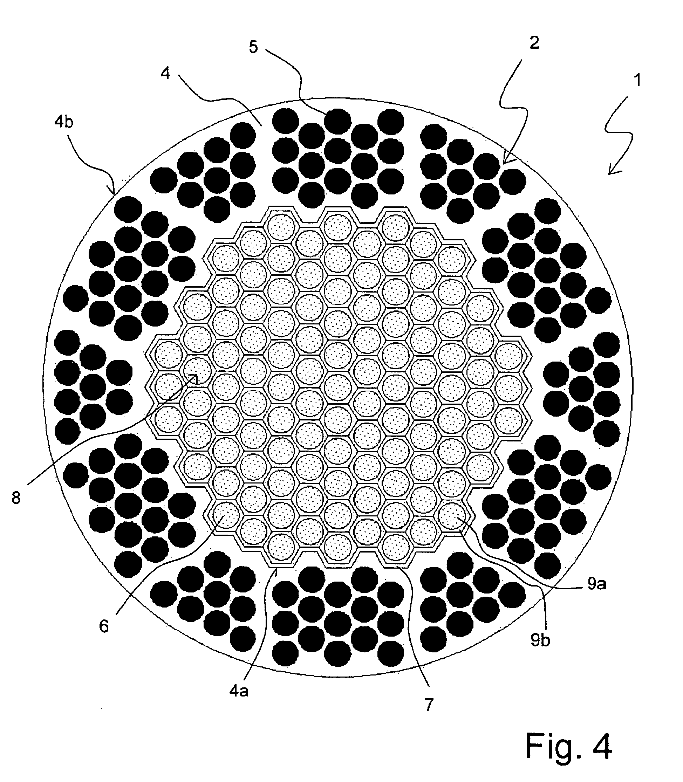

In more detail, the tube 1 has a round exterior shape 4b and the central hole 3 is of a special polygonal shape able to receive a number of 109 subelements 6, compare also **Fig. 4**, with just a small clearance 7 between the interior wall 4a of the tube 1 and the subelement bundle 8, enough to allow the insertion of all the subelements 6 during assembly. The 144 reinforcing filaments 5 in the wall 2 of the tube 1 are distributed in 12 groups separated by Cu-only areas.

In the final superconducting wire, the Cu-only areas separating the Ta filaments 5 (in addition to the Cu between the filaments 5 of each group) will serve at the fast removal of any electrical or thermal disturbances from the superconducting subelements 6 in the center.

In this preferred embodiment the reinforcing filaments 5 occupy ∼45% of the cross-sectional area of the wall 2 of the tube 1, whereas the central hole 3 takes ∼38% of the total cross-sectional area of the tube 1 (including the bore 3).

A superconductor wire will be prepared by (here) fabricating 109 subelements 6 containing the precursor materials 9a for the formation of a superconducting phase surrounded by a layer of Cu 9b and then assembling these subelements 6 in the described tube 1 (Fig. 4) and mechanically deforming them by wire drawing to form a round wire of a diameter suitable for the winding of magnet coils (usually between 0.5 and 2 mm). In the final wire, the reinforcing filaments 5 will occupy ∼28% of the total cross-sectional area of the wire, the rest of the area being divided between the Cu stabilizer and the 109 superconducting subelements 6 (excluding the Cu separating them, a maximum of ∼30% of total area). The content of reinforcing material and stabilizer Cu of the final wire can be adjusted by changing the size or the number of filaments 5 in the wall 2 of tube 1, for example by removing the outer layer of filaments 5 and reducing the external diameter of the tube 1 while keeping the rest of the filaments 5 and the central hole 3 unchanged.

For wires prepared using the tube 1 of this embodiment, the size of the superconducting subelements 6 in the final wire with a diameter of 0.80 mm (the so-called effective diameter) will be around 50 µm. As lower values of this parameter lead to improved stability of the wire at low magnetic fields and reduced power dissipation under alternating magnetic fields, a configuration with a higher number of subelements is also proposed (see embodiment Nr. 3 below). At the same final wire diameter the subelements 6 will end up having smaller effective diameters.

Fig. 4 presents the cross-section of the tube 1 of the preferred embodiment nr. 2, with 109 hexagonal subelements 6 assembled in the specially shaped central hole 3 of the tube 1.

### Preferred embodiment nr. 3

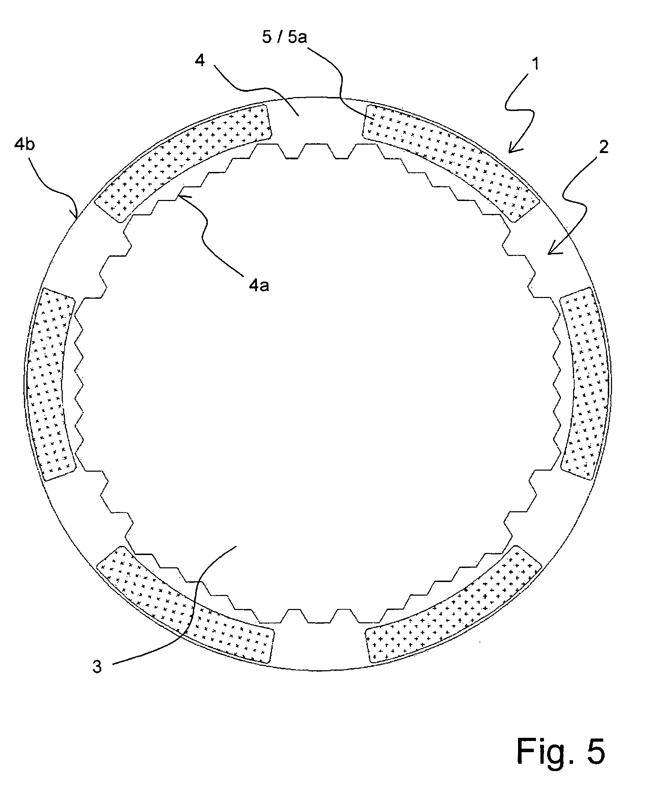

In another preferred embodiment, for applications where a lower level of reinforcement is needed, the reinforcing filaments 5 in the wall 2 of the tube 1 are shaped as annular sectors 5a and are made of Oxide Dispersion Strengthened (ODS) Cu, compare **Fig. 5**. Significantly stronger than Cu, this material has a relatively high electrical and thermal conductivity when compared with other materials of comparable strength. In a typical configuration, six annular segments 5a made of ODS-Cu would occupy two thirds of an annulus in the tube wall 2. The remainder of the annular segments, i.e. the matrix 4, will be made of high purity Cu ensuring an excellent electrical and thermal conductance along specific radial paths. This embodiment is also particularly suitable for the fabrication of Nb₃Sn superconductors.

Fig. 5 presents the cross-section of the tube 1 of the preferred embodiment nr. 3, with six ODS Cu filaments 5 in the Cu wall 2 of the tube 1. The external shape 4b of the tube 1 is round whereas the internal bore (hole) 3 is shaped for receiving a number of (here) 253 hexagonal subelements.

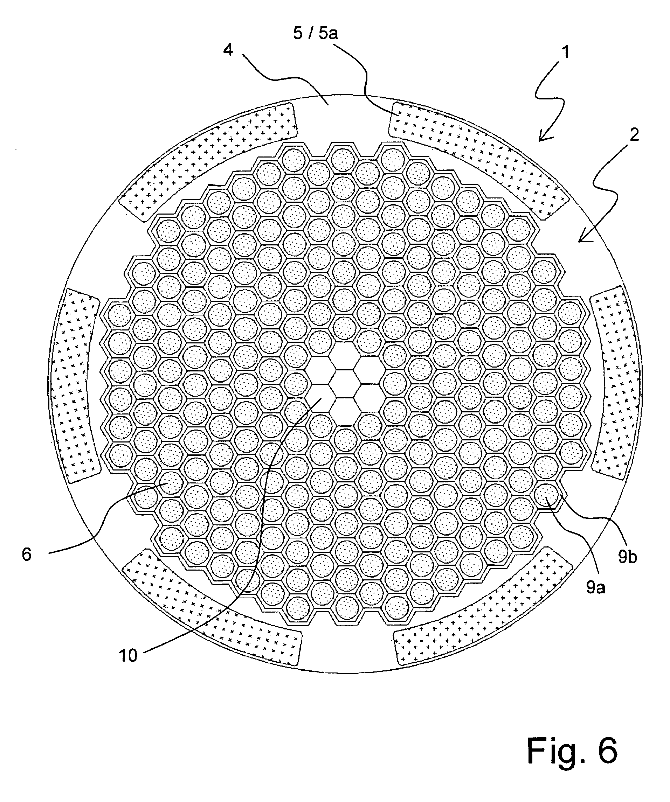

The ODS-Cu reinforcement occupies between 40 and 50 % of the cross-sectional area of the wall 2 of the tube 1, but higher ratios can be also used, in particular if the radial high conductance Cu paths are reduced in size. When the tube 1 is provided with a polygonal hole 3 able to receive 253 hexagonal subelements 6, 10 (compare **Fig. 6**) and taking ∼67% of the overall cross-sectional area of the tube 1 (including the bore 3), it can be used to fabricate reinforced internal Sn or powder in tube type Nb₃Sn superconductors with relatively low subelement effective diameter. For a final wire diameter of 0.80 mm, the estimated subelement effective diameter will be just above 40 µm. The reinforcement of such superconductor would occupy 13-17% of the total cross-sectional area of the wire, whereas the superconducting cores 9a of the subelements 6 will occupy 50-55%.

If more stabilizer Cu of high conductivity is needed for stability and/or mechanical deformation reasons, some of the central subelements 6, 10 assembled in the tube 1 can be made of pure Cu (as exemplified in Fig. 6 with the seven hexagonal subelements 10 in the center).

Fig. 6 presents the cross-section of the tube 1 of the preferred embodiment nr. 3, with 253 hexagonal subelements 6, 10 assembled in the specially shaped central hole 3 of the tube 1. Some of the subelements 6, 10 in the center of the assembly (seven in this case) may be replaced with Cu hexagonal rods 10 if more stabilizer is needed or to improve the drawing of the wire.

### Preferred embodiment nr. 4

For the fabrication of MgB₂ powder in tube type superconductors it is desirable to use tubes of materials that do not react significantly with Mg, B or MgB₂ during the reaction heat treatment. The formation of the intermetallic compound MgCu₂ eliminates Cu as a material coming in contact with the precursor powders of MgB₂ superconductors. Fe, Ni, Nb, Ta or Ti will not react significantly with the MgB₂ precursors and hence these metals are the usual materials for such applications, either in the form of a tube or as a barrier separating the MgB₂ precursor powders from the rest of the tube that contains the powders. In the case of a barrier, the tube material can be of any metal that has the proper combination of yield strength and deformability to allow the successful deformation into an elongated rod for future restacking to form a multifilament wire. Even in the presence of a barrier, Cu is often too soft to be material of the tube containing the MgB₂ precursor powders, and the assembly cannot be successfully deformed to the desired size.

As a solution to this problem, the invention proposes a tube that combines the good electrical and thermal properties of Cu with the strength of Fe or Ni by embedding Cu filaments in the wall of a tube made of Fe or Ni. The material in contact with the MgB₂ precursor powders would then be compatible (i.e. nonreactive with respect to MgB₂), whereas the Cu filaments would provide paths of high electrical and thermal conductivity that will improve the stability of the wire. The relatively high strength of the tube wall will allow the successful deformation of the precursor.

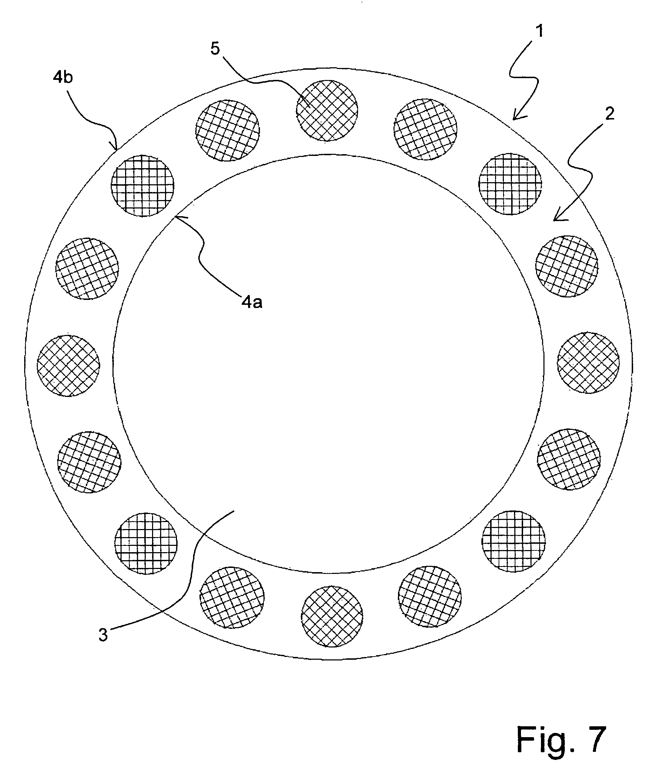

In the round tube 1 exemplified in **Fig. 7**, the sixteen Cu filaments 5 occupy ∼30% of the cross-sectional area of the wall 2 of the tube 1. The cross-sectional area of the wall 2 of the tube 1 is roughly equal to the cross-sectional area of the round central bore (hole) 3 of the tube 1. Depending on the method of fabrication, the filaments 5 may be round as presented in Fig. 7 or have other shapes, like oval or sector of annular region.

Fig. 7. presents the cross-section of a variant of the tube 1 of the preferred embodiment nr. 4, with sixteen Cu filaments 5 in the wall 2 of the tube 1 made of Fe or Ni.

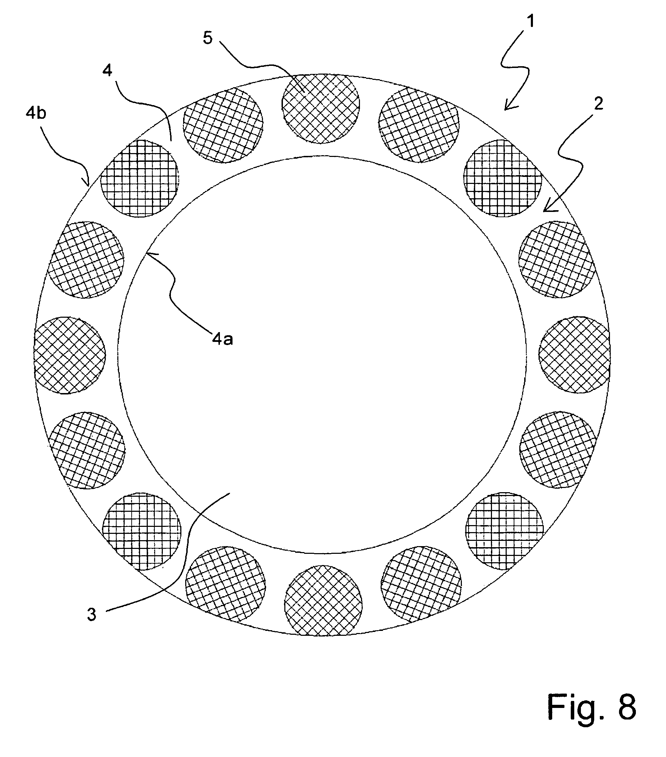

A further improvement of the electrical and thermal properties of the tube 1 of this embodiment can be achieved by exposing part of the Cu filaments 5 at the outer surface 4b of a tube 1, see **Fig. 8**, wherein the tube 1 was initially fabricated as the tube 1 in Fig. 7. To expose the Cu filaments 5, a mechanical or chemical process for removing a layer of material at the outside 4b of tube 1 will be employed during the fabrication of the tube 1 or at some stage during the deformation of the assembled precursor. The Cu filaments 5 in such a design can typically occupy 40% of the cross-sectional area of the tube wall 2.

Fig. 8 presents the cross-section of a variant of the tube 1 of the preferred embodiment nr. 4, with sixteen Cu filaments 5 in the wall 2 of the tube 1, with the matrix 4 made of Fe or Ni, wherein the Cu filaments 5 were exposed at the outer surface 4b of the tube 1.

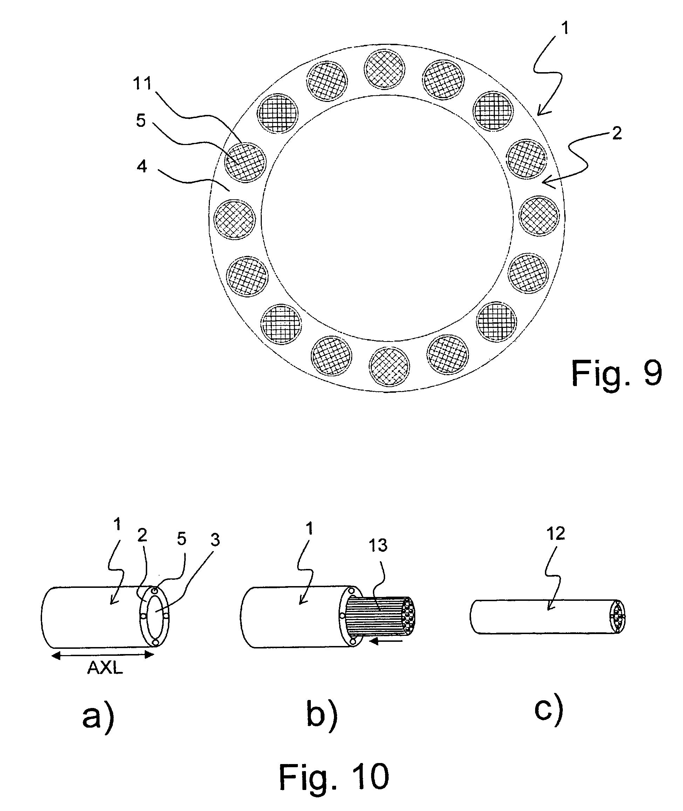

**Fig. 9** illustrates in a cross-section of a fifth embodiment of an inventive tube 1, wherein the filaments 5 are sheathed with a barrier 11 each (made of Nb or Ta for example). The sheathed filaments 5 are embedded in the matrix 4 of the tube wall 2. The materials of the filaments 5, the barrier 11 and the matrix 4 are all different from each other. By means of the barrier 11, unwanted reactions or interdiffusion of the matrix material and the filament material can be prevented.

**Fig. 10** illustrates the fabrication of a compound 12 in accordance with the invention.

In a step a), an inventive tube 1 with reinforcing filaments 5 in the tube wall 2 is provided. Typically, each filament 5 extends through the complete axial length AXL of the tube 1.

In a step b), superconducting material or superconductor precursor material is inserted into the bore 3 of the tube 1. In the example shown, a bundle of superconductor precursor rods 13 is inserted into the bore 3.

Afterwards, in step c), the tube 1 including the superconductor precursor rods 13 is mechanically deformed. The resulting component 12 has an increased axial length, but a reduced diameter as compared to the tube 1. The component 12 is subjected to a heat treatment afterwards, in order to react the precursor material on the precursor rods 13 into superconducting material. Then the component 12 may be used as a superconducting wire, e.g. in a magnet coil.

Note that the dimensions in Fig. 10 are not drawn to scale.

### 7. References

[1] T. Luhman, C. J. Klamut, M. Suenaga, and D. Welch, "Superconducting wire with improved strain characteristics," United States of America Patent 4,343,867, Aug. 10 1982.
[2] E. Gregory, L. R. Motowidlo, G. M. Ozeryansky, and L. T. Summers, "High strength Nb3Sn conductors for high magnetic field applications," IEEE Trans. Magn., vol. 27, pp. 2033-2036, 1991.
[3] S. Nakayama, S. Murase, K. Shimamura, N. Aoki, and N. Shiga, "Alumina dispersion-strengthened copper alloy matrix Ti added Nb3Sn wire by the tube process," Adv. Cryo. Eng., vol. 38, pp. 279-284, 1992.
[4] J. Chen, K. Han, P. N. Kalu, and W. D. Markiewicz, "Aluminum oxide particle strengthened niobium tin superconducting composite wire," United States of America Patent Application 2008/0146451 A1, Jun. 19 2008.
[5] G. A. Whitlow and N. C. lyer, "High temperature superconductor having a high strength thermally matched high temperature sheath," United States of America Patent 5,017,553, May 21 1991.
[6] K. W. Lay, "Oxide superconductor tape having silver alloy sheath with increased hardness," United States of America Patent 5,384,307, Jan. 26 1995.
[7] L. J. Masur, D. L. Parker, E. R. Podtburg, P. R. Roberts, R. D. Parrella, J. Riley, G. N., and S. Hancock, "Performance of oxide dispersion strengthened superconductor composites," United States of America Patent 6,436,875 B2, Aug. 20 2002.
[8] L. J. Masur, D. R. Parker, E. R. Podtburg, P. R. Roberts, R. D. Parrella, J. Riley, G. N., and S. Hancock, "Performance of oxide dispersion strengthened superconductor composites," United States of America Patent 6,305,070 B1, Oct. 23 2001.
[9] E. R. Podtburg, "Precursor composites for oxygen dispersion hardened silver sheathed superconductor composites," United States of America Patent 5,914,297, Jun. 22 1999.
[10] S. Murase, H. Shiraki, O. Horigami, M. Koizumi, S. Mine, H. Takeda, and H. Baba, "Stress effects on W/Cu reinforced Nb3Sn composite conductors," in Filamentary A15 superconductors, M. Suenaga and A. F. Clark, Eds. New York: Plenum Press, 1980, pp. 233-240.
[11] C. Spencer, E. Adam, E. Gregory, S. O. Hong, D. A. Koop, and G. Reverri, "Development and fabrication of 12 Tesla Nb3Sn superconductors," IEEE Trans. Magn., vol. 17, pp. 1006-1009, 1981.
[12] C. R. Spencer, E. Adam, and E. Gregory, "Development of an internally strengthened Nb3Sn conductor," Adv. Cryo. Eng., vol. 28, pp. 815-820, 1982.
[13] R. Flükiger, W. Goldacker, W. Specking, L. Pintschovius, W. Müllner, and J. Ekin, "Effect of reinforcing steel on the crystal structure and critical current density of Nb3Sn multifilamentary wires," in ICMC-9 International Cryogenic Materials Conference, Kobe, Japan, 1982, pp. 17-20.
[14] J. W. Ekin, R. Flükiger, and W. Specking, "Effect of stainless steel reinforcement on the critical current versus strain characteristic of multifilamentary Nb3Sn superconductors," J. Appl. Phys., vol. 54, pp. 2869-2871, 1983.
[15] R. Flükiger, E. Drost, W. Goldacker, and W. Specking, "Superconducting and mechanical properties of internally steel reinforced Nb3Sn wires with Ta or (Ni+Zn) additions," IEEE Trans. Magn., vol. 19, pp. 1441-1444, 1983.
[16] R. Flükiger, E. Drost, and W. Specking, "Effect of the internal reinforcement on the critical current density of Nb3Sn wires," Adv. Cryo. Eng., vol. 30, pp. 875-882, 1984.
[17] K. Noto, N. Konishi, A. Hoshi, K. Watanabe, M. Noguchi, and T. Fukutsuka, "A new reinforcing stabilizer for superconducting wires-Al2O3 dispersion strengthened copper --," in 9th International Conference on Magnet Technology, Zurich, Switzerland, 1985, pp. 700-703.
[18] S. Pourrahimi and N. Pourrahimi, "Method for reinforcing superconducting coils with high-strength materials," United States of America Patent 7,275,301 B2, Oct. 2 2007.
[19] J. D. Scudiere, D. M. Buczek, G. L. Snitchler, and P. J. Di Pietro, "Laminated superconducting ceramic tape," United States of America Patent 5,987,342, Nov. 16 1999.
[20] S. Murase, S. Nakayama, Y. Yamada, K. Shimamura, M. Tezuka, N. Shiga, K. Watanabe, and N. Kobayashi, "Highly-strengthened alumina-copper alloy matrix (Nb,Ti)3Sn conductors fabricated by using the tube process," IEEE Trans. Magn., vol. 32, pp. 2937-2940, 1996.
[21] K. Noto, M. Matsukawa, C. Takahashi, H. Konno, Y. Saito, K. Yamazaki, T. Yoshida, H. Yamada, K. Ikeda, T. Sato, and H. Kawabe, "High-conductivity high-strength Cu-Nb composites," Cryogenics, vol. 30 September Supplement, pp. 383-387, 1990.
[22] K. Watanabe, S. Awaji, K. Noto, K. Goto, M. Sugimoto, T. Saito, and O. Kohno, "Cu-Nb reinforcing stabilizer for Nb3Sn," in 7th US-Japan workshop on high-field superconducting materials, wires and conductors, and standardizing procedures for high-field superconducting wires testing, Fukuoka, Japan, 1991, pp. 148-152.
[23] M. Matsukawa, K. Noto, K. Katagiri, N. Matsuura, M. Ikebe, C. Takahashi, T. Fukutsuka, and K. Watanabe, "Heavily cold worked high-purity Ta as a reinforcing stablilizer," IEEE Trans. Magn., vol. 28, pp. 880-883, 1992.
[24] G. Iwaki and A. Kimura, "Nb₃Sn-system superconductive wire," United States of America Patent 6,849,137 B2, Feb. 1 2005.
[25] K. Arai, H. Tateishi, M. Umeda, and K. Agatsuma, "Fiber-reinforced-superconductors for a 15T-class high-field pulsed magnet and their conceptual design," IEEE Trans. Appl. Supercond., vol. 3, pp. 555-558, 1993.
[26] K. Arai, H. Tateishi, M. Umeda, and K. Agatsuma, "Titanium or tantalum additions to Nb3Sn layers from reinforcement fibers in fiber-reinforced-superconductors," IEEE Trans. Appl. Supercond., vol. 5, pp. 1591-1594, 1995.
[27] H. Tateishi, K. Arai, and K. Agatsuma, "Properties of multifilamentary Nb3Sn fiber-reinforced superconductors for high field pulsed magnets," IEEE Trans. Appl. Supercond., vol. 5, pp. 1587-1590, 1995.
[28] K. Itoh, M. Yuyama, T. Kiyoshi, T. Takeuchi, K. Inoue, H. Maeda, T. Miyatake, and M. Shimada, "Development of NbTi and Nb3Sn conductors for 1GHz NMR spectrometer," in ICEC16/ICMC: 16th International Cryogenic Engineering Conference and International Cryogenic Materials Conference and Industrial Exhibition, Kitakyushu, Japan, 1996, pp. 1735-1738.
[29] T. Hase, Y. Murakami, S. Hayashi, Y. Kawata, Y. Kawate, T. Kiyoshi, H. Wada, and T. Miyazaki, "Bronze route conductors for 1 GHz NMR superconducting magnet," IEEE Trans. Appl. Supercond., vol. 10, pp. 965-970, 2000.
[30] G. Roth and H. Krauth, "Reinforced superconductor element," United States of America Patent 7,514,634 B2, Apr. 7 2009.

## Claims

1. A component (12), comprising a hollow tube (1) and superconducting material or superconductor precursor material such as superconductor precursor rods (13) arranged within the bore (3) of the tube (1), wherein the tube (1) extends along an axial direction,
wherein the tube (1) comprises a matrix (4) made of a first ductile material, wherein a plurality of continuous filaments (5) are distributed in the matrix (4), wherein the continuous filaments (5) are made of a second ductile material,
**characterized in**
**that** the continuous filaments (5) extend along the axial direction of the tube (1) over a length that is at least ten times larger than the outer diameter of the tube each.

2. A component (12) according to claim 1, **characterized in that** the continuous filaments (5) have a length that corresponds to the tube length each.

3. A component (12) according to claim 1 or 2, **characterized in**
**that** the first ductile material of the matrix (4) is a material, in particular metal or alloy, of high electrical and thermal conductivity, i.e. with an electrical conductivity σ1 and a thermal conductivity k1 which are larger than the electrical conductivity σ2 and the thermal conductivity k2 of the second ductile material of the filaments (5),
and **that** the second ductile material of the filaments (5) is a material, in particular a metal or alloy, of high yield strength, i.e. with a yield strength ys2 which is larger than the yield strength ys1 of the first material of the
matrix (4).

4. A component (12) according to claim 1 or 2, **characterized in that** the second ductile material of the filaments (5) is a material, in particular metal or alloy, of high electrical and thermal conductivity, i.e. with an electrical conductivity σ2 and a thermal conductivity k2 which are larger than the electrical conductivity σ1 and the thermal conductivity k1 of the first ductile material of the matrix (4),
and that the first material of the matrix (4) is a material, in particular metal or alloy, of high yield strength, i.e. with a yield strength ys1 which is larger than the yield strength ys2 of the second material of the filaments (5).

5. A component (12) according to one of the claims 3 or 4, **characterized in that** the material of high electrical and thermal conductivity is from the group Cu, Cu alloy, Ag, Ag alloy.

6. A component (12) according to one of the claims 3 through 5, **characterized in** the material of high yield strength is from the group Nb, Nb alloy, Ta, Ta alloy, Ti, Ti alloy, V, V alloy, Zr, Zr alloy, Hf, Hf alloy, Mo, Mo alloy, Fe, Fe alloy, Ni, Ni alloy, Cu alloy.

7. A component (12) according to one of the claims 3 through 6, **characterized in that** the material of high yield strength is a metal-matrix composite made of
- a metal matrix, in particular of Cu or a Cu-based solid solution alloy, and
- particles or non-continuous fibers, in particular of one or more of the materials Nb, Nb alloy, Ta, Ta alloy, Ti, Ti alloy, V, V alloy, Zr, Zr alloy, Hf, Hf alloy, Mo, Mo alloy, Fe, Fe alloy, Ni, Ni alloy.

8. A component (12) according to any one of the preceding claims,
**characterized in that** the tube (1) has a bore (3) with a shape (4a) that corresponds to the outer shape of a bundle of rods (8) each having a polygonal, in particular hexagonal, or round cross-section.

9. A component (12) according to one of the preceding claims,
**characterized in that** the ratio AB/AT of the cross-sectional area AB of the bore (3) of the tube (1) and the cross sectional total area AT of the matrix (4) and the filaments (5) is between 0.25 and 9, preferably between 0.5 and 2.

10. A component (12) according to one of the preceding claims,
**characterized in that** the filaments (5) distributed in the matrix (4) occupy between 10% and 90%, preferably between 35% and 55%, of the total area AT of matrix (4) and filaments (5).

11. A component (12) according to one of the preceding claims,
**characterized in that** the continuous filaments (5) within the matrix (4) are sheathed with a third ductile material, different from the first ductile material of the matrix (4) and of the second ductile material of the filaments (5).

12. A component (12) according to one of the preceding claims, **characterized in that** every filament (5) is completely surrounded by matrix material in cross-section.

13. A method for producing a component (12) according to one of the claims 1 through 12, in particular wire or rod or tape,
**characterized by** a sequence of the following steps:
a) the hollow tube (1) is provided,
b) the superconducting material or superconductor precursor material, in
particular a plurality of superconductor precursor rods (13), is inserted into the bore (3) of the hollow tube (1),
c) the tube (1) including the superconducting material or superconductor precursor material undergoes a mechanical deformation, wherein the tube (1) is reduced in diameter size.

14. A method according to claim 13, **characterized in that** step c) is accompanied by or followed by generation of heat, wherein the superconductor precursor material reacts into its corresponding superconductor.

15. A method according to one of the claims 13 or 14, **characterized in that** a part of the tube material is removed from the periphery of the tube (1), thus reducing the outer diameter of the tube (1),
in particular wherein after the removal of the tube material, filaments (5) are exposed at the outer surface (4b) of the tube (1).

## Patentansprüche

1. Komponente (12) umfassend ein hohles Rohr (1) und supraleitendes Material oder Supraleiter-Vorläufer-Material, wie beispielsweise Supraleiter-Vorläufer-Stäbe (13), welches innerhalb der Bohrung (3) des Rohrs (1) angeordnet ist, wobei das Rohr (1) sich entlang einer axialen Richtung erstreckt,
wobei das Rohr (1) eine Matrix (4) aus einem ersten duktilen Material umfasst, wobei eine Vielzahl von kontinuierlichen Filamenten (5) in der Matrix (4) verteilt sind, wobei die kontinuierlichen Filamente (5) aus einem zweiten duktilen Material gefertigt sind,
**dadurch gekennzeichnet,**
**dass** die kontinuierlichen Filamente (5) sich jeweils entlang der axialen Richtung des Rohrs (1) über eine Länge erstrecken, die mindestens zehn mal so groß ist wie der Außendurchmesser des Rohrs.

2. Komponente (12) nach Anspruch 1, **dadurch gekennzeichnet, dass** die kontinuierlichen Filamente (5) eine Länge haben, die jeweils der Rohrlänge entspricht.

3. Komponente (12) nach Anspruch 1 oder 2, **dadurch gekennzeichnet, dass** das erste duktile Material der Matrix (4) ein Material, insbesondere ein Metall oder eine Legierung, von hoher elektrischer Leitfähigkeit und Wärmeleitfähigkeit ist, d.h. mit einer elektrischen Leitfähigkeit σ1 und einer Wärmeleitfähigkeit k1, die größer als die elektrische Leitfähigkeit σ2 und die Wärmeleitfähigkeit k2 des zweiten duktilen Materials der Filamente (5) sind,
und dass das zweite duktile Material der Filamente (5) ein Material, insbesondere ein Metall oder eine Legierung, von hoher Streckfestigkeit ist, d.h. mit einer Streckfestigkeit ys2, die größer als die Streckfestigkeit ys1 des ersten Materials der Matrix (4) ist.

4. Komponente (12) nach Anspruch 1 oder 2, **dadurch gekennzeichnet, dass** das zweite duktile Material der Filamente (5) ein Material, insbesondere ein Metall oder eine Legierung, von hoher elektrischer Leitfähigkeit und Wärmeleitfähigkeit ist, d.h. mit einer elektrischen Leitfähigkeit σ2 und einer Wärmeleitfähigkeit k2, die größer als die elektrische Leitfähigkeit σ1 und die Wärmeleitfähigkeit k1 des ersten duktilen Materials der Matrix (4) sind,
und dass das erste Material der Matrix (4) ein Material, insbesondere ein Metall oder eine Legierung, von hoher Streckfestigkeit ist, d.h. mit einer Streckfestigkeit ys1, die größer als die Streckfestigkeit ys2 des zweiten Materials der Filamente (5) ist.

5. Komponente (12) nach einem der Ansprüche 3 oder 4, **dadurch gekennzeichnet, dass** das Material von hoher elektrischer Leitfähigkeit und Wärmeleitfähigkeit aus der Gruppe Cu, Cu-Legierung, Ag, Ag-Legierung stammt.

6. Komponente (12) nach einem der Ansprüche 3 bis 5, **dadurch gekennzeichnet, dass** das Material von hoher Streckfestigkeit aus der Gruppe Nb, Nb-Legierung, Ta, Ta-Legierung, Ti, Ti-Legierung, V, V-Legierung, Zr, Zr-Legierung, Hf, Hf-Legierung, Mo, Mo-Legierung, Fe, Fe-Legierung, Ni, Ni-Legierung, Cu-Legierung stammt.

7. Komponente (12) nach einem der Ansprüche 3 bis 6, **dadurch gekennzeichnet, dass** das Material von hoher Streckfestigkeit ein MetallMatrix-Verbund ist, gefertigt aus
- einer Metallmatrix, insbesondere aus einer Feststofflösungs-Legierung aus Cu oder auf Cu-Basis,
und
- Teilchen oder nicht-kontinuierliche Fasern, insbesondere aus einem oder mehreren der Materialien Nb, Nb-Legierung, Ta, Ta-Legierung, Ti, Ti-Legierung, V, V-Legierung, Zr, Zr-Legierung, Hf, Hf-Legierung, Mo, Mo-Legierung, Fe, Fe-Legierung, Ni, Ni-Legierung.

8. Komponente (12) nach einem der vorhergehenden Ansprüche, **dadurch gekennzeichnet, dass** das Rohr (1) eine Bohrung (3) hat mit einer Form (4a), die der äußeren Form eines Bündels von Stäben (8) entspricht, die jeweils einen polygonalen, insbesondere hexagonalen, oder runden Querschnitt haben.

9. Komponente (12) nach einem der vorhergehenden Ansprüche, **dadurch gekennzeichnet, dass** das Verhältnis AB/AT der Querschnittsfläche AB der Bohrung (3) des Rohrs (1) und der gesamten Querschnittsfläche AT der Matrix (4) und der Filamente (5) zwischen 0,25 und 9, vorzugsweise zwischen 0,5 und 2, liegt.

10. Komponente (12) nach einem der vorhergehenden Ansprüche, **dadurch gekennzeichnet, dass** die Filamente (5), die in der Matrix (4) verteilt sind, zwischen 10% und 90%, vorzugsweise zwischen 35% und 55%, der Gesamtfläche AT der Matrix (4) und Filamente (5) einnehmen.

11. Komponente (12) nach einem der vorhergehenden Ansprüche, **dadurch gekennzeichnet, dass** die kontinuierlichen Filamente (5) innerhalb der Matrix (4) mit einem dritten duktilen Material ummantelt sind, das sich von dem ersten duktilen Material der Matrix (4) und dem zweiten duktilen Material der Filamente (5) unterscheidet.

12. Komponente (12) nach einem der vorhergehenden Ansprüche, **dadurch gekennzeichnet, dass** jedes Filament (5) im Querschnitt vollständig von Matrixmaterial umgeben ist.

13. Verfahren zum Herstellen einer Komponente (12) nach einem der Ansprüche 1 bis 12, insbesondere eines Drahts oder Stabs oder Bands, **gekennzeichnet durch** eine Abfolge folgender Schritte:
a) das hohle Rohr (1) wird bereitgestellt,
b) das supraleitende Material oder Supraleiter-Vorläufer-Material, insbesondere eine Vielzahl von Supraleiter-Vorläufer-Stäben (13), wird in die Bohrung (3) des hohlen Rohrs (1) eingeführt,
c) das Rohr (1) einschließlich des supraleitenden Materials oder Supraleiter-Vorläufer-Material wird einer mechanischen Verformung unterzogen, wobei der Durchmesser des Rohrs (1) reduziert wird.

14. Verfahren nach Anspruch 13, **dadurch gekennzeichnet, dass** während oder nach Schritt c) Wärme erzeugt wird, wobei das Supraleiter-Vorläufer-Material zu seinem entsprechenden Supraleiter reagiert.

15. Verfahren nach einem der Ansprüche 13 oder 14, **dadurch gekennzeichnet, dass** ein Teil des Rohrmaterials von dem Umfang des Rohrs (1) entfernt wird, wodurch der Außendurchmesser des Rohrs (1) kleiner wird, insbesondere wobei nach dem Entfernen des Rohrmaterials Filamente (5) an der Außenfläche (4b) des Rohrs (1) freiliegen.

## Revendications

1. Composant (12) comprenant un tube creux (1) et un matériau supraconducteur ou un matériau de précurseur supraconducteur tel que des tiges de précurseur supraconducteur (13) agencées au sein de l'alésage (3) du tube (1),
où le tube (1) s'étend le long d'une direction axiale,
où le tube (1) comprend une matrice (4) constituée d'un premier matériau ductile, où une pluralité de filaments continus (5) sont répartis dans la matrice (4), où les filaments continus (5) sont constitués d'un deuxième matériau ductile,
**caractérisé en ce**
**que** les filaments continus (5) s'étendent chacun le long de la direction axiale du tube (1) sur une longueur qui est au moins dix fois plus importante que le diamètre extérieur du tube.

2. Composant (12) selon la revendication 1, **caractérisé en ce que** les filaments continus (5) présentent chacun une longueur qui correspond à la longueur du tube.

3. Composant (12) selon la revendication 1 ou 2, **caractérisé en ce que** le premier matériau ductile de la matrice (4) est un matériau, en particulier un métal ou un alliage, de haute conductivité électrique et thermique, c'est-à-dire présentant une conductivité éclectique σ1 et une conductivité thermique k1 qui sont supérieures à la conductivité électrique σ2 et à la conductivité thermique k2 du deuxième matériau ductile des filaments (5),
et **en ce que** le deuxième matériau ductile des filaments (5) est un matériau, en particulier un métal ou un alliage, de haute limite d'élasticité, c'est-à-dire présentant une limite d'élasticité ys2 qui est supérieure à la limite d'élasticité ys1 du premier matériau de la matrice (4).

4. Composant (12) selon la revendication 1 ou 2, **caractérisé en ce que** le deuxième matériau ductile des filaments (5) est un matériau, en particulier un métal ou un alliage, de haute conductivité électrique et thermique, c'est-à-dire présentant une conductivité électrique σ2 et une conductivité thermique k2 qui sont supérieures à la conductivité électrique σ1 et à la conductivité thermique k1 du premier matériau ductile de la matrice (4),
et **en ce que** le premier matériau de la matrice (4) est un matériau, en particulier un métal ou un alliage, de haute limite d'élasticité, c'est-à-dire présentant une limite d'élasticité ys1 qui est supérieure à la limite d'élasticité ys2 du deuxième matériau des filaments (5).

5. Composant (12) selon l'une des revendications 3 ou 4, **caractérisé en ce que** le matériau de haute conductivité électrique et thermique est issu du groupe constitué du Cu, d'un alliage de Cu, d'Ag, d'un alliage d'Ag.

6. Composant (12) selon l'une des revendications 3 à 5, **caractérisé en ce que** le matériau de haute limite d'élasticité est issu du groupe constitué du Nb, d'un alliage de Nb, du Ta, d'un alliage de Ta, du Ti, d'un alliage de Ti, du V, d'un alliage de V, du Zr, d'un alliage de Zr, du Hf, d'un alliage de Hf, du Mo, d'un alliage de Mo, du Fe, d'un alliage de Fe, du Ni, d'un alliage Ni, d'un alliage de Cu.

7. Composant (12) selon l'une des revendications 3 à 6,
**caractérisé en ce que** le matériau de haute limite d'élasticité est une matrice métallique composite constituée
- d'une matrice métallique, en particulier constituée de Cu ou d'un alliage de solution solide à base de Cu, et
- de particules ou de fibres non continues, en particulier constituées d'un ou de plusieurs des matériaux issus du groupe constitué du Nb, d'un alliage de Nb, du Ta, d'un alliage de Ta, du Ti, d'un alliage de Ti, du V, d'un alliage de V, du Zr, d'un alliage de Zr, du Hf, d'un alliage de Hf, du Mo, d'un alliage de Mo, du Fe, d'un alliage de Fe, du Ni, d'un alliage de Ni.

8. Composant (12) selon l'une quelconque des revendications précédentes, **caractérisé en ce que** le tube (1) présente un alésage (3) ayant une forme (4a) qui correspond à la forme extérieure d'un faisceau de tiges (8) ayant chacune une section transversale polygonale, en particulier hexagonale, ou ronde.

9. Composant (12) selon l'une des revendications précédentes, **caractérisé en ce que** le rapport AB/AT de la surface de section transversale AB de l'alésage (3) du tube (1) et de la surface totale de section transversale AT de la matrice (4) et des filaments (5) est compris entre 0,25 et 9, de préférence entre 0,5 et 2.

10. Composant (12) selon l'une des revendications précédentes, **caractérisé en ce que** les filaments (5) répartis dans la matrice (4) occupent entre 10 % et 90 %, de préférence entre 35 % et 55 %, de la surface totale AT de la matrice (4) et des filaments (5).

11. Composant (12) selon l'une des revendications précédentes, **caractérisé en ce que** les filaments continus (5) au sein de la matrice (4) sont recouverts d'un troisième matériau ductile, différent du premier matériau ductile de la matrice (4) et du deuxième matériau ductile des filaments (5).

12. Composant (12) selon l'une des revendications précédentes, **caractérisé en ce que** chaque filament (5) est complètement entouré par un matériau de matrice en section transversale.

13. Procédé destiné à produire un composant (12) selon l'une des revendications 1 à 12, en particulier un câble ou une tige ou une bande,
**caractérisé par** une séquence des étapes suivantes :
a) le tube creux (1) est fourni,
b) le matériau supraconducteur ou le matériau de précurseur supraconducteur, en particulier une pluralité de tiges de précurseur supraconducteur (13), est inséré dans l'alésage (3) du tube creux (1),
c) le tube (1) comprenant le matériau supraconducteur ou le matériau de précurseur supraconducteur subit une déformation mécanique, où le tube (1) voit sa dimension de diamètre réduite.

14. Procédé selon la revendication 13, **caractérisé en ce que** l'étape c) est accompagnée ou suivie d'une génération de chaleur, où le matériau de précurseur supraconducteur réagit pour former son supraconducteur correspondant.

15. Procédé selon l'une des revendications 13 ou 14, **caractérisé en ce qu'**une partie du matériau de tube est retirée de la périphérie du tube (1), réduisant ainsi le diamètre extérieur du tube (1),
en particulier où après le retrait du matériau de tube, les filaments (5) sont exposés au niveau de la surface extérieure (4b) du tube (1).
